(19) Europäisches Patentamt

European Patent Office

Office européen des brevets

(11) **EP 4 109 709 A1**

(12) **EUROPEAN PATENT APPLICATION**

(43) Date of publication:
**28.12.2022 Bulletin 2022/52**

(21) Application number: **22176560.5**

(22) Date of filing: **31.05.2022**

(51) International Patent Classification (IPC):
*H02J 7/00* (2006.01)    *H04B 3/54* (2006.01)

(52) Cooperative Patent Classification (CPC):
**H02J 7/00034; H02J 7/0071; H02J 7/00711;**
**H04B 3/542; H04B 3/548;** H02J 2310/46

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(30) Priority: **22.06.2021 SE 2150806**

(71) Applicant: **CTEK Sweden AB**
**776 70 Vikmanshyttan (SE)**

(72) Inventor: **SVEDLUND, Jerry**
**792 37 MORA (SE)**

(74) Representative: **Brann AB**
**P.O. Box 3690**
**Sveavägen 63**
**103 59 Stockholm (SE)**

(54) **METHOD FOR COMMUNICATION BETWEEN A BATTERY CHARGER AND AN ELECTRICALLY CONNECTED VEHICLE**

(57)    The present disclosure relates to method performed by a battery charger (110) configured to notify an electrically connected vehicle (120) about status of the battery charger (110), the method comprising measuring output (0) of the battery charger (110) to the electrically connected vehicle (120), determining a charging mode (CM) of the battery charger (110), determining pulse characteristics using the measured output and the determined charging mode (CM), generating a pulse train using the determined pulse characteristics, wherein the pulse train is indicative of the status of the battery charger.

Fig. 1

**Description**

**TECHNICAL FIELD**

The present invention relates to a method for communication between a battery charger and an electrically connected vehicle.

**BACKGROUND**

Vehicles typically comprises a battery, e.g., a starter battery used to crank the engine. The battery is typically charged using a battery charger.

In a scenario where a vehicle is parked, e.g., for long term storage, the vehicle is typically electrically connected to the battery charger for the entire stationary period.

To protect the battery, a smart charger will in some cases, such as with LiFePO4 batteries, halt charging when a certain level of charge has been achieved. In other words, the output voltage of the battery charger may for long periods match the voltage of the battery, and no current will flow from the battery charger to the battery.

Some conventional solutions involve having the vehicle to monitor the voltage level of the battery, and assume that there is a charger present if the voltage is elevated over a certain voltage, e.g., above the resting voltage of the battery. A drawback with such a solution is that any other charger or power source connected to the battery will have an impact on the battery/charging voltage, and trigger false detections. A further drawback is that simply monitoring the voltage level will not work when applied to a LiFePO4 battery, where the charger typically will stop elevating the voltage when it has finished charging the battery. However, for lead acid batteries, the chargers typically maintain a steady output voltage [13.6-13.8V], which is well above the resting voltage of a lead acid battery, the resting voltage rarely being above 13.1 V. A further drawback with such conventional solutions, is that it is not possible for the vehicle to know the status of the battery charger, e.g., if the battery charger is connected to the vehicle, what charging mode the battery charger is operating in, or if it is in a fault state.

A conventional battery charger is shown in US2005088144A1, where the battery charger comprises an interface 204 that may allow a user or a remote or local device to receive information relating to the battery or to a charging process over a dedicated data bus, such as a Controller Area Networks (CAN) bus.

Thus, there is a need for a method for notifying a vehicle about status of an electrically connected battery charger.

**OBJECTS OF THE INVENTION**

An objective of embodiments of the present invention is to provide a solution which mitigates or solves the drawbacks described above.

**SUMMARY**

The above objective is achieved by the subject matter described herein. Further advantageous implementation forms of the invention are described herein.

According to a first aspect of the invention the objects of the invention is achieved by a method performed by a battery charger configured to notify an electrically connected vehicle about status of the battery charger, the method comprising measuring output of the battery charger to the electrically connected vehicle, determining a charging mode of the battery charger, determining pulse characteristics using the measured output and the determined charging mode, and generating a pulse train using the determined pulse characteristics, wherein the pulse train is indicative of the status of the battery charger.

The advantage of this first aspect includes at least that an increased reliability of notifications is achieved, as the communication is adapted according to the charging mode the battery charger is operating in. A further advantage is that the complexity of the system can be reduced as existing cables for charging the battery can be used also for signaling.

According to a second aspect of the invention, the object of the invention is achieved by a method performed by a vehicle configured to be notified about status of an electrically connected battery charger, the method comprising monitoring an output received from the electrically connected battery charger, detecting a pulse train generated by the battery charger, decoding the generated pulse train to obtain information indicative of the status of the electrically connected battery charger.

According to a third aspect of the invention, the object of the invention is achieved by a battery charger configured to notify an electrically connected vehicle about status of the battery charger, the battery charger comprising a processor, and a memory, said memory containing instructions executable by said processor, wherein said battery charger is configured to perform the method according to the first aspect.

According to a fourth aspect of the invention, the object of the invention is achieved by a vehicle configured to be notified about status of an electrically connected battery charger, the vehicle comprising a processor, and a memory, said memory containing instructions executable by said processor, wherein said vehicle is configured to perform the method according to the second aspect.

According to a fifth aspect of the invention, the object of the invention is achieved by a computer program product comprising instructions which, when the program is executed by a computer, cause the computer to carry out the method according to the first or second aspect.

According to a sixth aspect of the invention, the object of the invention is achieved by a computer-readable storage medium comprising instructions which, when executed by a computer, cause the computer to carry out the steps of the method according to the first or second aspect.

The advantages of the second to the sixth aspects are at least the same as for the first aspect.

The scope of the invention is defined by the claims, which are incorporated into this section by reference. A more complete understanding of embodiments of the invention will be afforded to those skilled in the art, as well as a realization of additional advantages thereof, by a consideration of the following detailed description of one or more embodiments. Reference will be made to the appended sheets of drawings that will first be described briefly.

## BRIEF DESCRIPTION OF THE DRAWINGS

**Fig. 1** illustrates a charging system according to one or more embodiments of the present disclosure.

**Fig. 2** illustrates charging modes of a battery charger according to one or more embodiments of the present disclosure.

**Fig. 3** illustrates pulse characteristics according to one or more embodiments of the present application.

**Fig. 4** illustrates further pulse characteristics according to one or more embodiments of the present disclosure.

**Fig. 5** illustrates behavior of the battery charger operating in bulk charging mode according to one or more embodiments of the present disclosure.

**Fig. 6** illustrates behavior of the battery charger operating in absorption charging mode or constant voltage charging mode according to one or more embodiments of the present disclosure.

**Fig. 7** illustrates behavior of the battery charger operating in float charging mode according to one or more embodiments of the present disclosure.

**Fig. 8A-B** shows flowcharts according to one or more embodiments of the present disclosure.

**Fig. 9** shows the battery charger according to one or more embodiments of the present disclosure.

**Fig. 10** illustrates selection of positive or negative delta voltage values according to one or more embodiments of the present disclosure.

A more complete understanding of embodiments of the invention will be afforded to those skilled in the art, as well as a realization of additional advantages thereof, by a consideration of the following detailed description of one or more embodiments. It should be appreciated that like reference numerals are used to identify like elements illustrated in one or more of the figures.

## DETAILED DESCRIPTION

The present disclosure relates to a battery charger and a method thereof. The present disclosure further relates to a vehicle provided with a battery, and a method thereof.

The application of the disclosure herein relates to charging of vehicles in a stationary state, e.g., being parked up or placed in long-term storage.

Modern vehicles are typically provided with computational devices, such as Electronic Control Units, ECUs, for monitoring the status of the vehicle.

When auxiliary equipment is connected to the vehicle, it is generally desirable to monitor the status of such auxiliary equipment by the computational devices of the vehicle, e.g., Electronic Control Units. The status may optionally be encrypted or signed, to ensure integrity and authenticity of the transmitted status.

In one example, a battery charger may be electrically connected to the vehicle, and the computational devices may want to ensure that the status of the battery charger is connected to the vehicle.

In one further example, the battery charger may be electrically connected to the vehicle, and the computational devices may want to ensure that the battery charger provides a known behavior. E.g., has a sufficient maximum capacity, operates with a suitable algorithm for the current battery type, supports a particular communication format/protocol or is of a suitable model type.

In one further example, the battery charger may be electrically connected to the vehicle, and the computational devices may want to ensure that the battery charger is certified by the vehicle manufacturer and is of sufficient quality. E.g., the battery charger being certified according to a standard, being suitable to operate in a particular environment, e.g., maritime use. On other examples, the status might indicate max charging current, model of the charger, encryption information for integrity, authorization or authentication, information of standards the charger complies with, the charging algorithm applied, format of the status information (e.g., how many bits indicated by the pulse train).

In one further example, the battery charger may be electrically connected to the vehicle, and the computational devices may want to ensure that the battery of the vehicle is brought to/kept at a suitable/target level of charge, e.g., State of Charge, SoC.

Conventional solutions attempt to fill some of these needs by adding additional hardware. Examples of this is standardized plugs and dedicated signal lines and/or data buses, such as IEC 62196 connectors and/or CAN buses. Another example may be wireless communication equipment, such as Bluetooth or Wi-Fi equipment.

Drawbacks of such solution is that equipment complexity is increased as well as manufacturing costs.

The present disclosure overcome such disadvantages by utilizing the existing electrical coupling between the battery charger and the vehicle, e.g., charging cables provided with clamps adapted to be attached to poles of the battery.

Unlike in the case of power-line communication, where a modulated carrier signal is simply overlaid the periodic signal of the wiring system, a smart charger provides different output dependent on the charging mode in which it is operating in. In other words, the overall objective of the charger is to reach a target charging level of the battery as soon as possible without damaging the battery. When the battery charger is operating in constant current or bulk mode, the output capacity of the battery charger is operating at maximum capacity, and cannot be further be increased to account for modulation.

In other words, the output voltage of the charger cannot be further increased to generate a pulse.

The present disclosure solves this by adapting the modulation method and maximizing performance in each charging mode of the charger, e.g., bulk, absorption and float charging modes.

Generally, all terms used herein are to be interpreted according to their ordinary meaning in the relevant technical field, unless a different meaning is clearly given and/or is implied from the context in which it is used. All references to a/an/the element, apparatus, component, means, step, etc. are to be interpreted openly as referring to at least one instance of the element, apparatus, component, means, step, etc., unless explicitly stated otherwise. The steps of any methods disclosed herein do not have to be performed in the exact order disclosed, unless a step is explicitly described as following or preceding another step and/or where it is implicit that a step must follow or precede another step. Any feature of any of the embodiments disclosed herein may be applied to any other embodiment, wherever appropriate. Likewise, any advantage of any of the embodiments may apply to any other embodiments, and vice versa. Other objectives, features and advantages of the enclosed embodiments will be apparent from the following description.

An "or" in this description and the corresponding claims is to be understood as a mathematical OR which covers "and" and "or", and is not to be understand as an XOR (exclusive OR). The indefinite article "a" in this disclosure and claims is not limited to "one" and can also be understood as "one or more", i.e., plural.

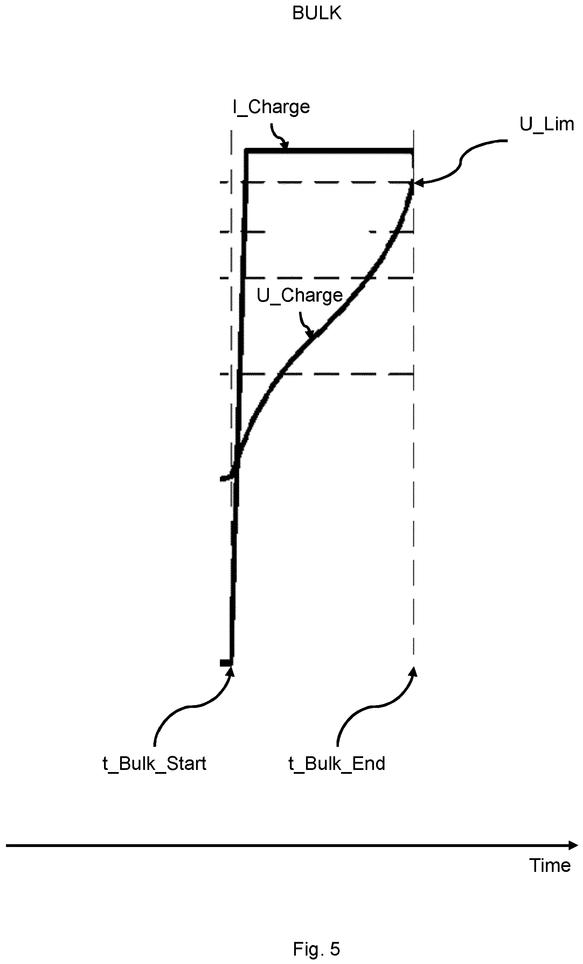

The term "battery charger" used herein denotes a smart charger or a charger provided with capabilities to execute instructions and operate in different (software controlled) charging modes. Charging modes are further described in relation to Fig. 5-7.

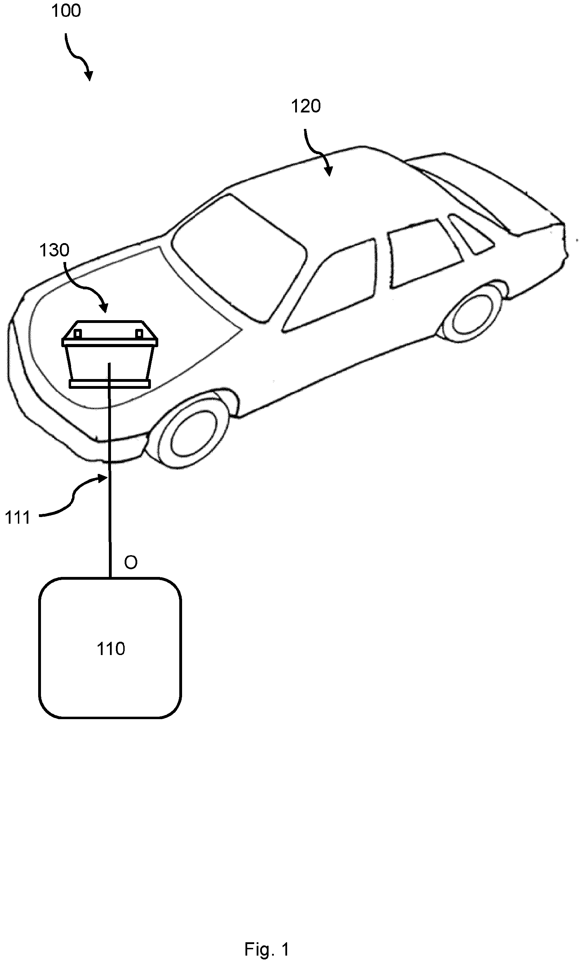

**Fig. 1** illustrates a charging system 100. The charging system 100 includes a battery charger 110, as described herein. The charging system 100 further includes a vehicle 120. The vehicle comprises a battery 130, e.g., a starter battery, a utility battery, or a battery to power the powertrain of the vehicle. The battery charger 110 is electrically coupled to the vehicle 120, e.g., via cables and clamps 111 to the battery 130 of the vehicle. The battery charger 110 provides an output O to the vehicle 120. The output is typically a certain output voltage and/or output current provided to the battery 130 of the vehicle 120.

As can be seen from Fig. 1, in the case where the charger 110 is electrically coupled to the vehicle 120 via cables and clamps 111 to the battery 130 of the vehicle, Any logic circuits in the vehicle 120 can only monitor charging characteristics such as charging current and charging voltage.

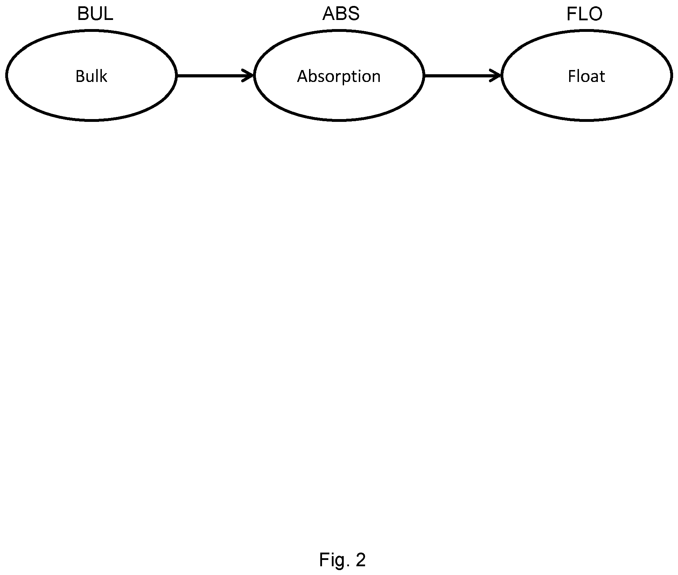

**Fig. 2** illustrates charging modes CM of a battery charger 110. A battery charger, or smart battery charger, typically operate subsequently in at least three charging modes, bulk, absorption and float. These modes may also be referred to as constant current charging mode, constant voltage charging mode and maintaining charging mode. Initiating charging of the battery, when using a smart charger, typically involves restarting a sequence of charging modes, such as bulk charging mode, absorption charging mode and float charging mode.

The bulk charging mode typically involves providing a maximum charging current and/or a constant current to the battery. The bulk charging mode is typically terminated when the battery/charging voltage has reached a limit voltage and/or a limit time. In an example involving a starter battery, the state of charge is then approximately at 80%.

The subsequent absorption charging mode, or constant voltage mode, typically applies a constant charging voltage and a dropping charging current for a certain period of time, or a limited current.

Once the battery has reached a second and higher state of charge, e.g., 96-98%, the float charging mode is typically entered. In the float charging mode, the voltage will taper down and maintain at a steady voltage.

Further details on charging modes are provided in relation to Fig. 5-7.

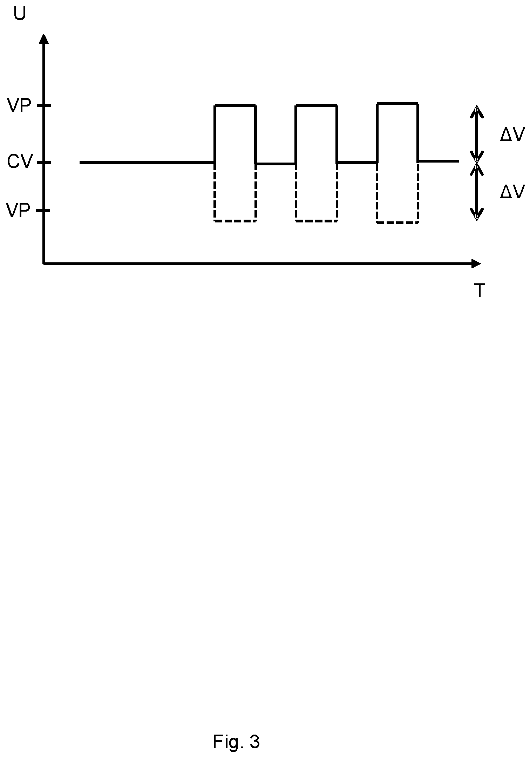

**Fig. 3** illustrates pulse characteristics according to one or more embodiments of the present application. Fig. 3 illustrates a diagram with two axes. The Y-axis illustrates a voltage of the output O of the battery charger 110, which normally is the same as the battery/charging voltage when the battery charger is electrically connected. The X-axis illustrates time passed. In other words, the diagram shows voltage output of the battery charger 110 over time. A battery/charging voltage or nominal charging voltage CV, i.e., voltage over battery poles of the battery 130 when connected to the charger, is measured, and is in this disclosure used as part of pulse characteristics as a baseline or voltage level of an off period in a pulse train. A delta voltage/delta voltage value $\Delta V$ is obtained and used to calculate voltage level of an on period in the pulse train. The delta voltage $\Delta V$ may e.g., be obtained as a predetermined value and stored in memory. Additionally, or alternatively, the delta voltage $\Delta V$ may be determined using a calibration procedure. As can be seen in Fig. 3, the delta voltage/ delta voltage value $\Delta V$ may be selected higher or lower than the output voltage of the battery/charging voltage CV.

Fig. 3 illustrates how the battery/charging voltage CV deviates a delta voltage $\Delta V$ used during a pulse on period and returns to nominal charging voltage CV in a pulse off period. Positive pulses are shown as solid lines and negative pulses are shown as dashed lines.

In other words, pulse characteristics may typically indicate a deviation or delta voltage value $\Delta V$ offsetting the output charging voltage CV of the battery charger 110 for a duration of a pulse. It is further understood that the pulse characteristics may further indicate the duration of a pulse. In other words, in some embodiments, the pulse characteristics at least defines pulse characteristics as voltage pulses.

In one example, calibration of pulse characteristics is performed by generating pulse trains using increasing voltage levels $\Delta V$ of the on period in the pulse train are sent to the vehicle. When the vehicle detects a pulse train, i.e., when a voltage level used to transmit the pulse train from the battery charger to the vehicle is sufficient to detect the pulse train, the voltage level is recorded and stored in memory for used as predetermined pulse characteristics.

In one further example, calibration of pulse characteristics is performed by generating pulse trains using decreasing voltage levels of the on period in the pulse train are sent to the vehicle. When the vehicle detects a pulse train, i.e., when a voltage level used to transmit the pulse train from the battery charger to the vehicle is sufficient to detect the pulse train, the vehicle then responds with a pulse train sent to the charger and mirroring the pulse train received from the battery charger. In this manner, pulse characteristics suitable for the electrically connected battery can be obtained.

As illustrated by the dashed lines in the diagram, the calculated voltage level of the on period in the pulse train may higher or lower than the measured battery/charging voltage or nominal charging voltage CV. The most important aspect is that the voltage level representing the off period is adapted to the nominal battery/charging voltage, and that the voltage level representing the on period can be clearly distinguished from the off period.

It is understood that detection/decoding of the pulse train can be performed by detecting rise flanks and/or fall flanks of the pulse train.

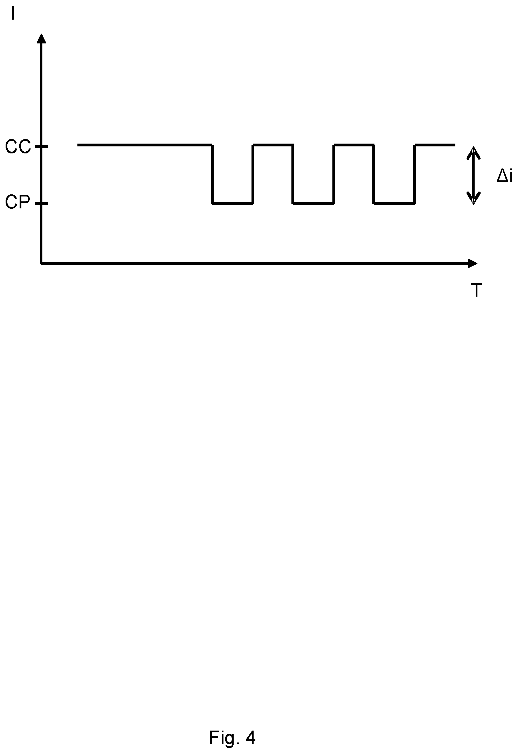

**Fig. 4** illustrates further pulse characteristics according to one or more embodiments of the present disclosure. Fig. 4 illustrates a diagram with two axes. The Y-axis illustrates a current of the output O of the battery charger 110. The X-axis illustrates time passed. In other words, the diagram shows current output of the battery charger 110 over time.

A battery/charging voltage CV, i.e., voltage over battery poles of the battery 130 when connected to the charger, is measured. Optionally, the measured battery/charging voltage CV may be used to look up a charging current or nominal charging current CC, e.g., in a look-up table. Optionally, the charging current CC may also be obtained as a predetermined value stored in memory. Optionally, the charging current may also be obtained by measuring the output current of the battery charger 110, i.e., measuring the current flowing from the battery charger 110 to the vehicle 120. However, this involves a more complex and expensive construction compared to voltage measurements.

Fig. 4 illustrates how the battery/charging current deviates a delta current $\Delta I$ used during a pulse on period and returns to nominal charging current CC in a pulse off period. Negative pulses are shown as dashed lines.

In other words, pulse characteristics may typically indicate a deviation or delta current value $\Delta I$ offsetting the

output charging current CC of the battery charger 110 for a duration of a pulse. It is further understood that the pulse characteristics may further indicate the duration of a pulse. In other words, in some embodiments, the pulse characteristics at least defines pulse characteristics as current pulses. A delta current/delta current value ΔI is obtained and used to calculate a current level of an on period in the pulse train, e.g., by adding the delta current ΔI to the charging current CC or subtracting the delta current ΔI from the charging current CC. The delta current ΔI may e.g., be obtained as a predetermined value and stored in memory. Additionally, or alternatively, the delta current ΔI may be determined using a calibration procedure.

In one example, the calibration procedure comprises pulse trains using increasing current levels CC+ΔI of the on period in the pulse train are sent to the vehicle. When the vehicle detects a pulse train, i.e., when a current level ΔI used to transmit the pulse train from the battery charger to the vehicle is sufficient to detect the pulse train by the vehicle, the current level is recorded and stored in memory for use as predetermined pulse characteristics. This may e.g., be performed in a laboratory or other controlled environment.

In one further example, the calibration procedure comprises pulse trains using decreasing current levels of the on period in the pulse train are sent to the vehicle. When the vehicle detects a pulse train, i.e., when a current level ΔI used to transmit the pulse train from the battery charger to the vehicle is sufficient to detect the pulse train, the vehicle may then respond by sending a pulse train mirroring the pulse train received from the battery charger. In this manner, pulse characteristics suitable for the electrically connected battery can be obtained.

In other words, a delta current value Δi may be stepwise increased until the pulse train is detected to calibrate to the current charging situation.

This calibration may e.g., be performed periodically to adopt to equipment wear and/or the environment of the vehicle.

**Fig. 5** illustrates behavior of the battery charger operating in bulk charging mode according to one or more embodiments of the present disclosure. Fig. 5 illustrates charging voltage and charging current output from the battery charger operating in the bulk charging mode, illustrated by the curves U_Charge for charging voltage and I_Charge for charging current respectively. At a first point in time t_Bulk_Start, charging in the bulk charging mode is initiated. The charging current is controlled and/or ramped up from substantially zero (0) Ampere to a target constant charging current I_Charge Ampere. At a second point in time t_Bulk_End, it is determined that charging in the bulk charging mode is completed, e.g., by determining that a first measured voltage over the poles of the battery is equal to or exceeds a voltage threshold U_Lim.

In one example, the battery charger is connected to two serially connected 12 V Lead-Acid batteries forming a 24 V battery pack. The battery/charging voltage when bulk charging is initiated is 23.2 Volts. At the first point in time t_Bulk_Start, a constant charging current of 10 Ampere is provided to the battery pack, i.e. I_Charge=10A. As can be seen in Fig. 1, the battery/charging voltage steadily increases until it reaches the voltage threshold U_Lim=28.8 Volt at the second point in time t_Bulk_End. From historical observations of battery charging curves, this implies that the State of Charge SoC has reached 80% at the second point in time t_Bulk_End. In other words, predetermined data indicates that when the voltage threshold U_Lim reaches 28.8 Volt, the battery pack as a SoC of 80%.

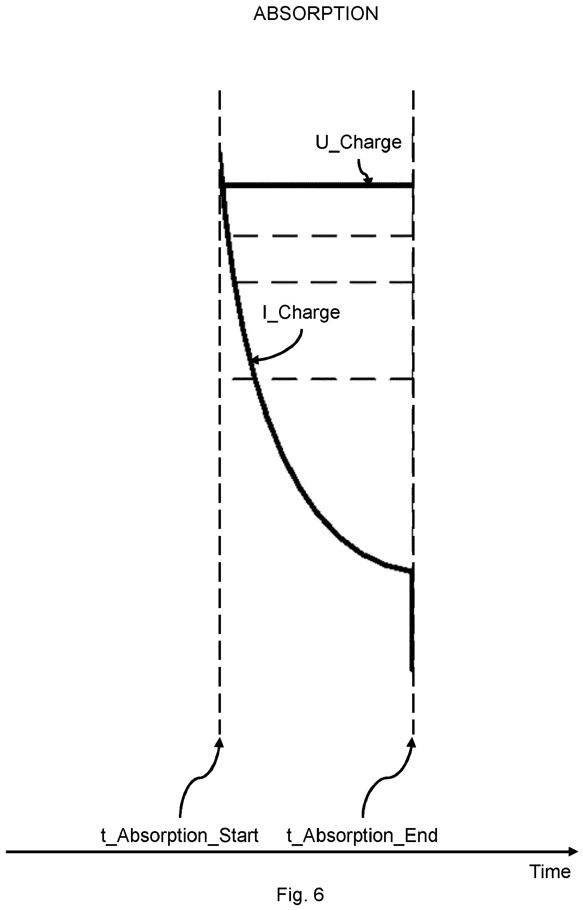

**Fig. 6** illustrates behavior of the battery charger operating in absorption charging mode or constant voltage charging mode according to one or more embodiments of the present disclosure. Fig. 6 illustrates charging voltage and charging current output from the battery charger operating in the absorption charging mode, illustrated by the curves U_Charge and I_Charge respectively. At a third point in time t_Absorption_Start, charging in the absorption mode is initiated. The charging voltage is then controlled to or kept at a substantially constant voltage, e.g., at the voltage threshold U_Lim as described in relation to Fig. 1. The charging current drops or is reduced over time, e.g., from the constant charging current I_Charge Ampere described in relation to Fig. 1. The charging voltage is maintained for a predetermined period of time, until a fourth point in time t_Absorption_End. The predetermined period of time may be given by a relation, e.g., a lookup table, relating the constant charging current used in the bulk charging mode I_Charge to a period of time. Examples of such period of time is 8 hours for a charging current of 20 Ampere, 6 hours for a charging current of 10 Ampere and 5 hours for a charging current of 8 Ampere.

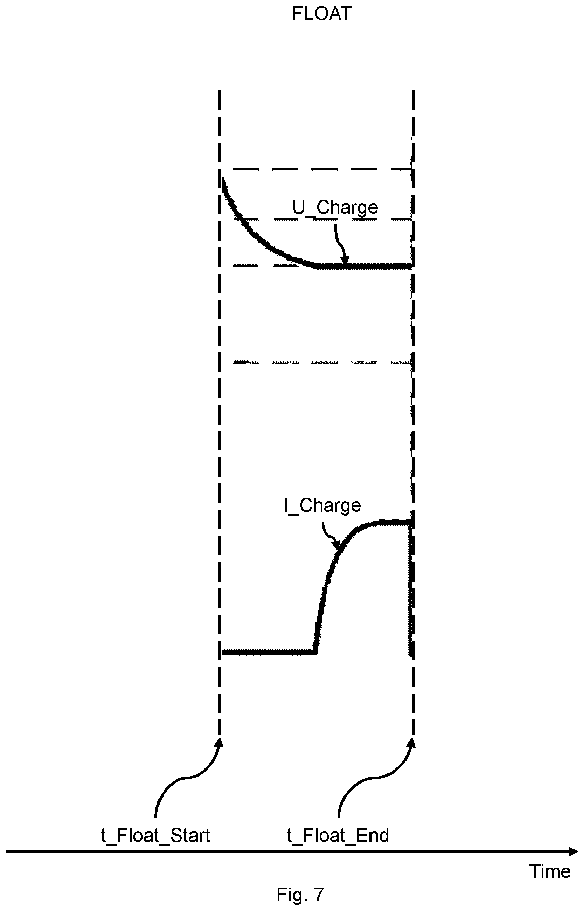

**Fig. 7** illustrates behavior of the battery charger operating in float charging mode according to one or more embodiments of the present disclosure. Fig. 7 illustrates charging voltage and charging current output from the battery charger operating in the float charging mode, illustrated by the curves U_Charge and I_Charge respectively. At a fifth point in time t_Float_Start, charging in the float mode is initiated. The charging voltage is then controlled to or kept at a substantially constant voltage, e.g., at a voltage close to a nominal open circuit voltage and lower than the constant voltage used the absorption charging mode, e.g., lower than U_Lim as further described in relation to Fig. 5 and Fig. 6. The charging current is limited to a predetermined current equal to an expected self-discharge current and a standby current. The constant charging voltage is maintained for a predetermined period of time until a sixth point in time t_Float_End. The predetermined period of time may be limited to a maximum of 10 days or 240 hours.

In one example, the float charging mode has been preceded by an absorption charging mode, where the charging voltage has been controlled to or kept at a substantially constant voltage, e.g., at the voltage threshold U_Lim as described in relation to Fig. 1. E.g., at U_Lim= 28.8 Volt. The charging voltage is then allowed to smoothly drop down close to a nominal open circuit voltage, e.g., 27.2 Volt, which is then kept constant for the duration of the float charge mode.

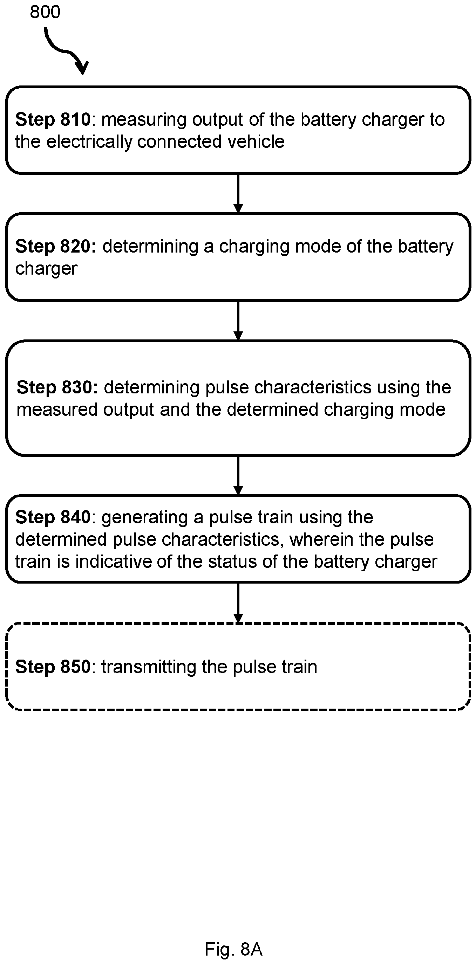

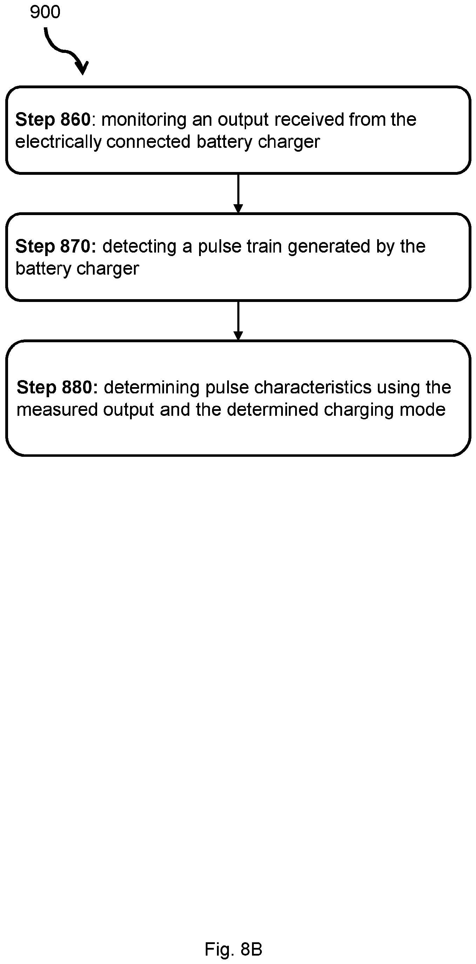

**Fig. 8** shows a flowchart of a method according to one or more embodiments of the present disclosure. The method is performed by a battery charger 110 configured to notify an electrically connected vehicle 120 about status of the battery charger 110. The method comprises:

**Step 810:** measuring output O of the battery charger 110 to the electrically connected vehicle 120.

In a preferred embodiment, output voltage of the charger is measured, which effectively will be the same as a voltage over the poles of the battery, therefore from heron denoted battery/charging voltage CV. The battery/charging voltage may be measured using any suitable method in the art, e.g., by using two serially coupled impedances or resistors as a voltage divider.

It is understood that measurement of output current is also possible, but generally involves a more complex and costly solution.

**Step 820:** determining a charging mode CM of the battery charger 110. The charging mode CM of the battery charger 110 may in embodiments e.g., be obtained by a processor 912 of the battery charger 110 from memory 915. In other words, the battery charger 110 is aware of the charging mode it is operating in.

In a further embodiment, the charging mode CM is determined using the measured output O of the battery charger 110 and historic values of the measured output O, e.g., by comparing the measured output O to a predetermined charging curve for a battery.

**Step 830:** determining pulse characteristics using the measured output and the determined charging mode CM. Pulse characteristics typically includes characteristics such as output voltage and/or output current representing an on period in the pulse train and/or output voltage and/or output current representing an off period in the pulse train. Pulse characteristics may further include pulse shape, pulse duration, duty cycle etc.

As shown in relation to Fig. 3, pulse characteristics may be determined and defined as voltage pulses having a deviation or delta voltage value $\Delta V$ offsetting the nominal output charging voltage CV of the battery charger 110 for a duration of a pulse. Pulse characteristics may further comprise predetermined duration of a pulse. In other words, in some embodiments, the pulse characteristics at least defines pulse characteristics as voltage pulses.

In one example, a determination is made that the battery charger 110 is operating in absorption charging mode/constant voltage mode. The pulse characteristics is then defined as a delta voltage value $\Delta V$ offsetting the nominal output charging voltage CV of the battery charger 110. Under practical circumstances, when the charger is operating in absorption charging mode it is generally operating at maximum charging voltage, thus the battery/charging voltage CV and/or charging current CC may only be reduced, so the delta voltage value $\Delta V$ typically defines a negative pulse, as illustrated by dashed lines in Fig. 3.

In one further example, a determination is made that the battery charger 110 is operating in float charging mode/constant voltage mode. The pulse characteristics is then defined as a delta voltage value $\Delta V$ and/or delta current value $\Delta I$ offsetting the nominal output charging voltage CV and/or the nominal output charging current CC of the battery charger 110. Under practical circumstances, when the charger is operating in float charging mode it is generally not operating at maximum charging voltage or maximum charging current, thus the battery/charging voltage CV and/or charging current CC may both be increased or be reduced, so the delta voltage value $\Delta V$ typically defines a positive or negative pulse, as illustrated by solid and dashed lines respectively in Fig. 3. It is noted that in cases where the charger is operating at operating at maximum charging voltage or maximum charging current, the battery/charging voltage CV and/or charging current CC can only be be reduced.

As shown in relation to Fig. 4, pulse characteristics may be determined and defined as current pulses having a deviation or delta current value $\Delta I$ offsetting the nominal output charging current CC of the battery charger 110 for a duration of a pulse. Pulse characteristics may further comprise predetermined duration of a pulse. In other words, in some embodiments, the pulse characteristics at least defines pulse characteristics as current pulses.

In one example, a determination is made that the battery charger 110 is operating in bulk charging mode/constant current mode. The pulse characteristics is then defined as a delta current value $\Delta I$ offsetting the nominal output charging current CC of the battery charger 110. Under practical circumstances, when the charger is operating in bulk charging mode it is generally operating at maximum charging current, thus the battery/charging voltage CV and/or charging current CC may only be reduced, so the delta current value $\Delta I$ typically defines a negative pulse, as illustrated in Fig. 4.

**Step 840:** generating a pulse train using the determined pulse characteristics, wherein the pulse train is indicative of the status of the battery charger. Generating a pulse train involves generating a series of voltage and/or current pulses. A pulse typically represents an on period. The absence of a pulse typically represents an off period. The on period may represent a digital 1 (one) and the off period may represent a digital 0 (zero), or vice versa. The number of pulses may be defined by a communication protocol, and may differ dependent on the status provision capability of the battery charger.

In one example, generating a pulse train comprises obtaining data to be sent, e.g., indicative of status of the battery charger 110 or characteristics of the charging process. Generating a pulse train further comprises encoding each bit of the obtained data to an on period or off period, as described above.

**Optional step 850:** Transmitting the pulse train from the battery charger 110 to the vehicle 120. A mentioned previously, the pulse train is sent via the electrical coupling 111 between the battery charger and the vehicle.

In other words, the pulse train is generated and transmitted as the output O of the battery charger 110.

In one example, transmitting the pulse train comprises transmitting the data as a series of on periods and/or off periods, where a pulse typically represents an on period. The absence of a pulse typically represents an off period. The on period may represent a digital 1 (one) and the off period may represent a digital 0 (zero), or vice versa.

The number of pulses may be defined by a communication protocol, and may differ dependent on the status provision capability of the battery charger.

The electrical coupling 111 between the battery charger and the vehicle is typically clamps/connectors and cables.

In one example, the battery charger is operating in bulk mode and the status of the battery charger is "operational and electrically connected". The output voltage is measured and used to determine a charging current, e.g., using a charging curve. Alternatively, the charging current is retrieved from memory 915, e.g., as a predetermined value.

In other words, the transmitted data is indicative of the status of the battery charger.

In one example, the battery charger is operating in absorption charging mode and the status of the battery charger is "maximum charging current 16 Amperes", "Charging behavior LiFePO4". The output voltage is measured and used to determine pulse characteristics in the form of pulse voltage higher or lower $\Delta V$ than the measured output/charging voltage CV. Alternatively, the pulse voltage is retrieved from memory 915, e.g., as a predetermined value.

In one example, the battery charger is operating in float charging mode and the status of the battery charger is "Certified by Ferrari" and "suitable for operating in desert climate".

In one example, the battery charger is operating in float charging mode and the status of the battery charger is "target level SoC 97%".

An advantage of the present disclosure, is that if the charging mode CM is determined to be in a bulk charging mode, the method determines pulse characteristics that will perform well in bulk charging mode and ensure safe transfer of the status information of the battery charger in this particular charging mode.

In one or more embodiments, the charging mode CM is determined as a bulk charging mode. The measured output includes a measured battery/charging voltage CV, and the pulse characteristics is further determined using a charging current CC of the battery charger and a delta current/delta current value $\Delta I$. In one example, the charging current CC is predetermined and optionally stored in memory.

In one example, the charging current CC is determined using the measured battery/charging voltage CV and a predetermined charging curve of a battery. In one or more embodiments, the pulse characteristics is indicative of a pulse voltage VP, where the pulse characteristics is indicative of a pulse voltage VP. The pulse voltage VP may be calculated according to the relation:

pulse voltage VP = battery/charging voltage CV $\pm$ delta voltage $\Delta V$ value, where delta voltage $\Delta V$ value is calculated as:

$$\text{delta voltage } \Delta V \text{ value} = \text{battery impedance } Z * \text{delta current } (\Delta I)$$

The battery impedance Z may be determined using the relation:

$$\text{battery impedance } Z = \text{battery/charging voltage CV/ charging current CC}$$

Under practical circumstances, when the charger is operating in bulk charging mode it is generally operating at maximum charging current, thus the battery/charging voltage CV may only be reduced, so the relation may be defined as:

$$\text{pulse voltage VP} = \text{battery/charging voltage CV - delta voltage } \Delta V \text{ value}$$

In one or more embodiments, the pulse characteristics is indicative of a pulse current CP, wherein the pulse current CP is calculated according to the relation: pulse current CP = charging current CC - delta current $\Delta I$. In other words, a delta current/delta current value $\Delta I$ is obtained and used to calculate a current level of an on period in the pulse train. The delta current $\Delta I$ may e.g., be obtained as a predetermined value and stored in memory. Additionally, or alternatively, the delta current $\Delta I$ may be determined using a calibration procedure, as further described in relation to Fig. 4.

If the charging mode CM is determined to be in an absorption charging mode, the method determines pulse characteristics that will perform well and ensure safe transfer of the status information of the battery charger in the absorption charging mode.

In one or more embodiments, the charging mode CM is determined as an absorption ABS charging mode. The measured output includes a measured battery/charging voltage CV, and the pulse characteristics is further determined using a charging current CC of the battery charger and a delta voltage ΔV value. In one or more embodiments, the charging mode is determined as an absorption charging mode. The measured output includes a measured battery/charging voltage CV, and the pulse characteristics is further determined using the measured battery/charging voltage CV and a delta voltage ΔV value. I.e., a delta voltage/delta voltage value ΔV is obtained and used to calculate voltage level VP of an on period in the pulse train. The delta voltage ΔV may e.g., be obtained as a predetermined value and stored in memory. Additionally, or alternatively, the delta voltage ΔV may be determined using a calibration procedure, as further described in relation to Fig. 3. Optionally, the pulse voltage VP is calculated according to the relation: pulse voltage VP = measured battery/charging voltage CV ± delta voltage ΔV value.

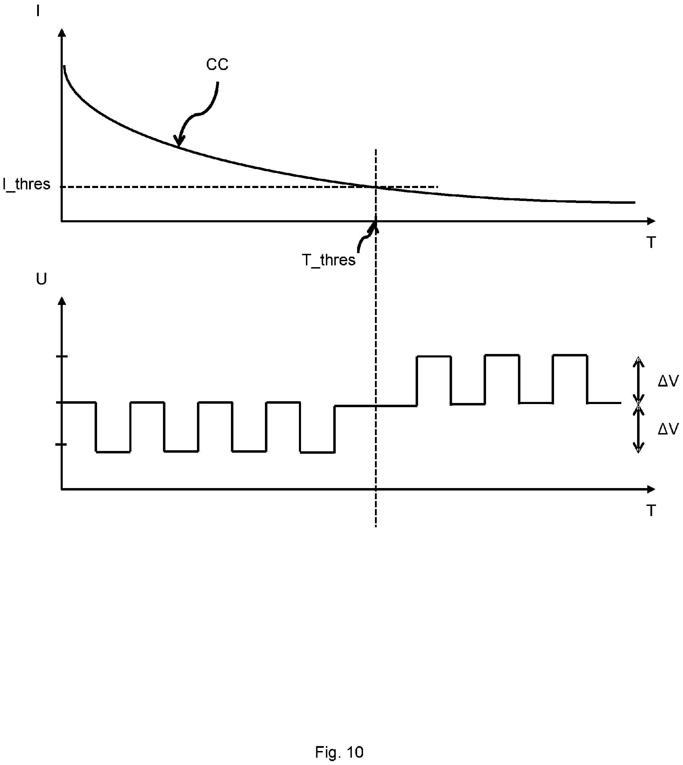

Optionally, the delta voltage ΔV value is selected as a negative value in a first half of a period where absorption charging mode is applied, and selected as a positive value in a succeeding half of the period. Selection of positive or negative values are further described in relation to Fig. 10.

If the charging mode CM is determined to be in a float charging mode, the method determines pulse characteristics that will perform well and ensure safe transfer of the status information of the battery charger in this particular charging mode.

In one or more embodiments, the charging mode is determined as a float charging mode, wherein the measured output includes a measured battery/charging voltage CV, and the pulse characteristics is further determined using the measured battery/charging voltage CV and a delta voltage ΔV value. Optionally, the pulse voltage VP is calculated according to the relation: pulse voltage VP = measured battery/charging voltage CV ± delta voltage ΔV value. Optionally, the delta voltage ΔV value is selected as a negative value in a first half of a period where float charging mode is applied, and selected as a positive value in a succeeding half of the period. I.e., a delta voltage/delta voltage value ΔV is obtained and used to calculate voltage level of an on period in the pulse train. The delta voltage ΔV may e.g., be obtained as a predetermined value and stored in memory. Additionally, or alternatively, the delta voltage ΔV may be determined using a calibration procedure, as further described in relation to Fig. 3.

According to a second aspect of the disclosure, a vehicle receives a notification about status of an electrically connected battery charger.

**Fig. 8B** shows a flowchart of a method according to one or more embodiments of the present disclosure. A method performed by a vehicle 120 configured to be notified about status of an electrically connected battery charger is provided. The method comprises:

**Step 860:** monitoring an output received from the electrically connected battery charger. Optionally, monitoring the output comprises measuring the battery/charging voltage CV or measuring the charging current CC.

In a further embodiment, the charging mode CM is determined using the measured output O of the battery charger 110 and historic values of the monitored and/or measured output O, e.g., by comparing the monitored and/or measured output O to a predetermined charging curve for a battery.

**Step 870:** detecting a pulse train generated by the battery charger.

In one example, detection of the pulse train can be performed by detecting rise flanks and/or fall flanks of the pulse train. The rise flanks and/or fall flanks are interpreted as a beginning or end of an end period.

**Step 880:** decoding the generated pulse train to obtain information indicative of the status of the electrically connected battery charger.

In one example, the detected flanks are each mapped to a bit or binary value 1/0 and appended to form one or more words or data sequences. The words or data sequences can then be mapped to a status of the battery charger according to a predefined an optionally propriety protocol and/or mapping. E.g., the first bit indicates battery charger is connected/operational, second to third bit indicate charging algorithm used etc.

In other words, the obtained information may be indictive of the battery charger being operationally active. In other words, the vehicle knows that the battery charger is electrically connected and is ready to charge the battery if required.

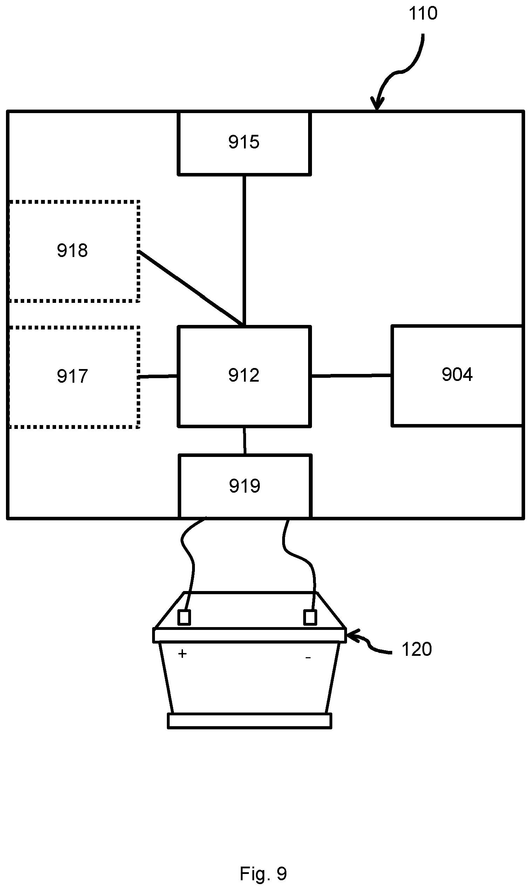

**Fig. 9** shows the battery charger 110 according to one or more embodiments of the present disclosure. The battery charger 110 may be in the form of e.g., a battery charger, an Electronic Control unit, a server, an on-board computer, a stationary computing device, a laptop computer, a tablet computer, a handheld computer, a wrist-worn computer, a smart watch, a smartphone or a smart TV. The battery charger 110 may comprise a processor/processing circuitry 912, optionally communicatively coupled to a communications interface 904, e.g., a transceiver configured for wired or wireless communication.

In one example, the processing circuitry 912 may be any of a selection of processing circuitry and/or a central processing unit and/or processor modules and/or multiple processors configured to cooperate with each-other.

Further, the battery charger 110 may further comprise a memory 915. The memory 915 may e.g., comprise a selection of a hard RAM, disk drive, a floppy disk drive, a flash drive or other removable or fixed media drive or any other suitable memory known in the art. The memory 915 may contain instructions executable by the processing circuitry to perform any of the steps or methods described herein.

The processing circuitry 912 may optionally be communicatively coupled to a selection of any of the communications interface 904, the memory 915, one or more sensors, such as battery/charging voltage sensors measuring battery/charging voltage over poles of the battery. The battery charger 110 may be configured to send/receive control signals directly to any of the above-mentioned units or to external nodes.

The communications interface 904, such as a wired network adapter and/or a wired, may be configured to send and/or receive data values or parameters as a signal to or from the processing circuitry 812 to or from other external nodes. E.g., measured battery/charging voltage values. In an embodiment, the communications interface 804 communicates directly to external nodes.

In one or more embodiments the battery charger 110 may further comprise an input device 917, configured to receive input or indications from a user and send a user input signal indicative of the user input or indications to the processing circuitry 912.

In one or more embodiments the battery charger 110 may further comprise a display 918 configured to receive a display signal indicative of rendered objects, such as text or graphical user input objects, from the processing circuitry 912 and to display the received signal as objects, such as text or graphical user input objects.

In one embodiment the display 918 is integrated with the user input device 917 and is configured to receive a display signal indicative of rendered objects, such as text or graphical user input objects, from the processing circuitry 912 and to display the received signal as objects, such as text or graphical user input objects, and/or configured to receive input or indications from a user and send a user-input signal indicative of the user input or indications to the processing circuitry 912.

In a further embodiment, the battery charger 110 may further comprise and/or be coupled to one or more additional sensors (not shown in the figure) configured to receive and/or obtain and/or measure physical properties pertaining to the battery charger 110, and send one or more sensor signals indicative of the physical properties of the battery charger 110 to the processing circuitry 912. E.g., an external voltage sensor measuring power grid voltage and/or ambient temperature.

In one or more embodiments, the processing circuitry 912 is further communicatively coupled to the communications interface 904 and/or the input device 917 and/or the display 918 and/or the controllable power source 919 and/or the sensors and/or the additional sensors and/or any of the units described herein.

In one embodiment, a battery charger 110 is provided and is configured to notify an electrically connected vehicle 120 about status of the battery charger 110, the battery charger 110 comprising a processor 912, and a memory 915, said memory containing instructions executable by said processor, whereby said battery charger 110 is operative and/ or configured to perform any of the method steps described herein.

Moreover, it is realized by the skilled person that the battery charger 110 may comprise the necessary communication capabilities in the form of e.g., functions, means, units, elements, etc., for performing the present solution. Examples of other such means, units, elements and functions are: processors, memory, buffers, control logic, encoders, decoders, rate matchers, de-rate matchers, mapping units, multipliers, decision units, selecting units, switches, modulators, demodulators, inputs, outputs, antennas, amplifiers, receiver units, transmitter units, DSPs, MSDs, TCM encoder, TCM decoder, power supply units, power feeders, communication interfaces, communication protocols, etc. which are suitably arranged together for performing the present solution.

Especially, the processing circuitry and/or processing means of the present disclosure may comprise one or more instances of processing circuitry, processor modules and multiple processors configured to cooperate with each-other, Central Processing Unit (CPU), a processing unit, a processing circuit, a processor, an Application Specific Integrated Circuit (ASIC), a microprocessor, a Field-Programmable Gate Array (FPGA) or other processing logic that may interpret and execute instructions. The expression "processing circuitry" and/or "processing means" may thus represent a processing circuitry comprising a plurality of processing circuits, such as, e.g., any, some or all of the ones mentioned above. The processing means may further perform data processing functions for inputting, outputting, and processing of data comprising data buffering and device control functions, such as user interface control, or the like.

**Fig. 10** illustrates selection of positive or negative delta voltage values according to one or more embodiments of the present disclosure. Fig. 10 shows a diagram with charging current on the vertical axis and time elapsed on the horizontal axis. When the battery charger is operating in absorption/constant voltage charging mode or float charging mode, the delta voltage value $\Delta V$ may be selected as a positive value or a negative value for different parts of a period where a particular charging mode is applied.

The pulse voltage VP is calculated according to the relation:

$$\text{pulse voltage VP} = \text{measured battery/charging voltage (CV)} \pm \text{delta voltage (}\Delta V\text{)}$$

value.

The delta voltage ∆V value may e.g., be selected as a negative value in a first part of a period where absorption charging mode is applied, and selected as a positive value in a succeeding part of the period where absorption charging mode is applied, or vice versa. This would e.g., be the case of absorption charging mode, where the output initially is operating at the maximum capacity of the charger.

The transition in selection between the negative value and the positive value is performed at a time T_thres when the charging current CC is below a current threshold I_thres. In one example, the current threshold I_thres may be selected as 50% of the charging current when operating in bulk charging mode/constant current charging mode.

Finally, it should be understood that the invention is not limited to the embodiments described above, but also relates to and incorporates all embodiments within the scope of the appended independent claims.

**Claims**

1. A method performed by a battery charger (110) configured to notify an electrically connected vehicle (120) about status of the battery charger (110), the method comprising:

   measuring output (O) of the battery charger (110) to the electrically connected vehicle (120),
   determining a charging mode (CM) of the battery charger (110),
   determining pulse characteristics using the measured output and the determined charging mode (CM),
   generating a pulse train using the determined pulse characteristics, wherein the pulse train is indicative of the status of the battery charger.

2. The method according to claim 1, wherein the charging mode (CM) is determined as a bulk charging mode, wherein the measured output includes a measured charging voltage (CV), and the pulse characteristics is further determined using a charging current (CC) of the battery charger and a delta current (∆I) value.

3. The method according to claim 2, wherein the pulse characteristics is indicative of the charging current (CC), wherein the pulse voltage (VP) is calculated according to the relation: pulse voltage (VP) = charging voltage (CV) - delta voltage (∆V) value, where delta voltage (∆V) value is calculated as delta voltage (∆V) value= battery impedance (Z) * delta current (∆I).

4. The method according to any of claims 2-3, wherein the pulse characteristics is indicative of a pulse current (CP), wherein the pulse current (CP) is calculated according to the relation: pulse current (CP) = charging current (CC) - delta current (∆I).

5. The method according to claim 1, wherein the charging mode is determined as an absorption charging mode, wherein the measured output includes a measured charging voltage (CV), and the pulse characteristics is determined using the measured charging voltage (CV) and a delta voltage (∆V) value.

6. The method according to claim 5, wherein the pulse voltage (VP) is calculated according to the relation: pulse voltage (VP) = measured charging voltage (CV) ± delta voltage (∆V) value.

7. The method according to claim 6, wherein the delta voltage (∆V) value is selected as a negative value in a first part of a period where absorption charging mode is applied, and selected as a positive value in a succeeding part of the period where absorption charging mode is applied, or vice versa.

8. The method according to claim 7, according to claim wherein the transition in selection between the negative value and the positive value is performed at a time (T_thres) when the charging current (CC) is below a current threshold (I_thres).

9. The method according to claim 1, wherein the charging mode is determined as a float charging mode, wherein the measured output includes a measured charging voltage (CV), and the pulse characteristics is further determined using the measured charging voltage (CV) and a delta voltage (∆V) value.

10. The method according to claim 9, wherein the pulse voltage (VP) is calculated according to the relation: pulse voltage (VP) = measured charging voltage (CV) ± delta voltage (∆V) value.

11. A method performed by a vehicle (120) configured to be notified about status of an electrically connected battery charger, the method comprising:

monitoring an output received from the electrically connected battery charger (110),
detecting a pulse train generated by the battery charger,
decoding the generated pulse train to obtain information indicative of the status of the electrically connected battery charger.

12. The method according to claim 11, wherein monitoring the output comprises measuring a battery/charging voltage (CV) and/or measuring a charging current (CC).

13. The method according to claim 12, wherein the obtained information is indictive of the battery charger being operationally active.

14. A battery charger (110) configured to notify an electrically connected vehicle (120) about status of the battery charger (110), the battery charger (110) comprising:

a processor (912), and
a memory (915), said memory containing instructions executable by said processor, wherein said battery charger (110) is configured to perform the method according to any of claims 1-10.

15. A vehicle (120) configured to be notified about status of an electrically connected battery charger (110), the vehicle comprising:

a processor, and
a memory, said memory containing instructions executable by said processor, wherein said vehicle (120) is configured to perform the method according to any of claims 11-13.

16. A computer program product comprising instructions which, when the program is executed by a computer, cause the computer to carry out the method according to any of claims 1-10 or 11-13.

17. A computer-readable storage medium comprising instructions which, when executed by a computer, cause the computer to carry out the steps of the method according to any of claims 1-10 or 11-13.

100

120

130

111

O

110

Fig. 1

BUL                          ABS                          FLO

Bulk            →            Absorption        →          Float

Fig. 2

Fig. 3

Fig. 4

BULK

Fig. 5

ABSORPTION

Fig. 6

FLOAT

Fig. 7

800

**Step 810**: measuring output of the battery charger to the electrically connected vehicle

**Step 820**: determining a charging mode of the battery charger

**Step 830**: determining pulse characteristics using the measured output and the determined charging mode

**Step 840**: generating a pulse train using the determined pulse characteristics, wherein the pulse train is indicative of the status of the battery charger

**Step 850**: transmitting the pulse train

Fig. 8A

900

**Step 860**: monitoring an output received from the electrically connected battery charger

**Step 870**: detecting a pulse train generated by the battery charger

**Step 880**: determining pulse characteristics using the measured output and the determined charging mode

Fig. 8B

Fig. 9

Fig. 10

Europäisches
Patentamt

European
Patent Office

Office européen
des brevets

# EUROPEAN SEARCH REPORT

Application Number

**EP 22 17 6560**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 10 2013 004630 A1 (VOLKSWAGEN AG [DE]) 2 October 2014 (2014-10-02) | 11-13, 15-17 | INV. H02J7/00 |
| A | * paragraphs [0052], [0056], [0057], [0063], [0083], [0122] * | 1-10,14 | H04B3/54 |
| | ----- | | |
| X | DE 10 2013 004638 A1 (VOLKSWAGEN AG [DE]) 18 September 2014 (2014-09-18) | 11-13, 15-17 | |
| A | * paragraphs [0064] - [0066], [0083], [0110] * | 1-10,14 | |
| | ----- | | |
| A | DE 10 2011 075836 B4 (CONTINENTAL AUTOMOTIVE GMBH [DE]) 21 February 2013 (2013-02-21) * the whole document * | 1-17 | |
| | ----- | | |

TECHNICAL FIELDS
SEARCHED      (IPC)

**H02J**
**H04B**

The present search report has been drawn up for all claims

| Place of search | Date of completion of the search | Examiner |
|---|---|---|
| **Munich** | **9 November 2022** | **Sulic, Tomislav** |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 17 6560

This annex lists the patent family members relating to the patent documents cited in the above-mentioned European search report.
The members are as contained in the European Patent Office EDP file on
The European Patent Office is in no way liable for these particulars which are merely given for the purpose of information.

09-11-2022

| Patent document cited in search report | Publication date | Patent family member(s) | Publication date |
|---|---|---|---|
| DE 102013004630 A1 | 02-10-2014 | NONE | |
| DE 102013004638 A1 | 18-09-2014 | NONE | |
| DE 102011075836 B4 | 21-02-2013 | NONE | |

EPO FORM P0459

For more details about this annex : see Official Journal of the European Patent Office, No. 12/82

**EP 4 109 709 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2005088144 A1